# EUROPEAN PATENT APPLICATION

(11) **EP 4 199 091 A1**
(43) Date of publication of application: **21.06.2023**
(21) Application number: 21215436.3
(22) Date of filing: 17.12.2021
(51) Int. Cl.: H01L 27/11556, H01L 27/11582

(54) **A MEMORY DEVICE**

(71) Applicant: Epinovatech AB, 223 63 Lund (SE)
(72) Inventor: OLSSON, Martin Andreas, 223 63 Lund (SE)
(74) Representative: AWA Sweden AB

(57) **Abstract**

A memory device (1) comprising a semiconductor pillar (40) and at least one memory cell (50) associated with the pillar (40), wherein each of the at least one memory cells (50) comprises a charge trap (60) and a transistor (2), wherein, for each of the at least one memory cells (50):
the charge trap (60) of the memory cell (50) is configured to control a threshold voltage of the transistor (2) of the memory cell (50) by a stored charge; and
the transistor (2) of the memory cell (50) comprises a source pillar segment (10), a drain pillar segment (14) and a body pillar segment (12),
wherein at least one p-doped pillar segment (10, 12, 14) of the transistor (2) comprises a plurality of semiconductor layers (20), wherein layers of the plurality of semiconductor layers (20) are made of AlGaN or GaN, and wherein the plurality of semiconductor layers (20) is configured such that every second layer has a lower aluminum content than the neighboring mutually opposite layers thereof.

## Description

### TECHNICAL FIELD

The present inventive concept relates, in general, to a memory device, use of a memory device, and a method for producing a memory device.

### BACKGROUND

Memory devices, such as electronic non-volatile memory devices, are extensively used in electronic devices. For example, flash memory may store information in the form of electric charge in memory cells. In order to increase the memory capacity, 3D integrated circuit technology may be used to stack memory cells in multiple layers. However, there is still room for further improvements of memory devices.

### SUMMARY

It is an objective of the present inventive concept to provide a memory device with high storage capacity. It is a further objective to provide a low-cost memory device. It is a further objective to provide a memory device for high-frequency operation and/or high-power operation and/or high-temperature operation. These and other objectives of the inventive concept are at least partly met by the invention as defined in the independent claims. Preferred embodiments are set out in the dependent claims.

In this text, abbreviations of the natural elements will be used in accordance with the periodic table. For example, Al means aluminum, Ga means gallium, As means arsenic, Mg means magnesium, O means oxygen, Si means silicon, N means nitrogen.

According to a first aspect, there is provided a memory device comprising a pillar of semiconductor material and at least one memory cell associated with the pillar, wherein each of the at least one memory cells comprises a charge trap and a transistor, wherein, for each of the at least one memory cells:
the charge trap of the memory cell is configured to store a charge and to control a threshold voltage of the transistor of the memory cell by said stored charge; and
the transistor of the memory cell comprises a source, a body, and a drain, wherein the source, body, and drain are respective pillar segments along an axial direction of the pillar, wherein a source pillar segment and a drain pillar segment are separated by a body pillar segment, wherein the transistor is either
   - a NPN transistor, wherein the source pillar segment is n-doped, the body pillar segment is p-doped, and the drain pillar segment is n-doped; or
   - a PNP transistor, wherein the source pillar segment is p-doped, the body pillar segment is n-doped, and the drain pillar segment is p-doped;
wherein at least one p-doped pillar segment of the transistor comprises a plurality of semiconductor layers stacked in the axial direction of the pillar, wherein layers of the plurality of semiconductor layers are made of AIGaN or GaN, and wherein the plurality of semiconductor layers is configured such that an aluminum content changes between each consecutive layer such that every second layer has a lower aluminum content than the neighboring mutually opposite layers thereof.

It is a realization that memory devices may comprise GaN based material. As used herein, the term "GaN based material" should be construed as any semiconductor material comprising gallium and nitrogen, e.g. GaN, AlGaN, InGaN, AlInGaN. According to the above, at least one p-doped pillar segment of the transistor of the memory cell comprises a plurality of semiconductor layers, wherein layers of the plurality of semiconductor layers are made of AIGaN or GaN, and wherein the plurality of semiconductor layers is configured such that an aluminum content changes between each consecutive layer. The other pillar segments of the transistor, e.g. the n-doped pillar segments, may comprise any GaN based material, e.g. GaN.

GaN based material may facilitate high-frequency operation and/or high-power operation and/or high-temperature operation. Thus, a memory device comprising GaN based material may operate at high frequencies and/or high power and/or high temperatures. Alternatively, or additionally, a memory device comprising GaN based material may be embedded with electronic devices also made of GaN based material, e.g. embedded in the same chip or on the same substrate.

P-doping may be hard to achieve in GaN based materials. Doping atoms, such as Mg, used for p-doping are often passivated by hydrogen impurities or nitrogen vacancies. Therefore, the free hole concentration may be low even if the doping concentration is high. To remove the passivation (or activate the doping atoms), post-growth annealing may be used, e.g. post-growth annealing in an atmosphere of low hydrogen concentration.

It is a realization that the plurality of semiconductor layers may remove or reduce the need for post-growth annealing of p-doped GaN based materials. This facilitates the production of NPN transistors and/or PNP transistors and thereby also facilitates the production of memory devices based on NPN or PNP transistors. Thus, the p-doped body pillar segment of a NPN transistor of a memory cell of the memory device may comprise said plurality of semiconductor layers. Alternatively, or additionally, the p-doped source and/or drain pillar segment of a PNP transistor of a memory cell of the memory device may comprise said plurality of semiconductor layers. Advantageously, both the p-doped source pillar segment and the drain pillar segment of a PNP transistor of a memory cell of the memory device may comprise said plurality of semiconductor layers.

The plurality of semiconductor layers may enhance the p-doping through a variation in the valence-band edge, as described by Kozodoy et al. [Appl. Phys. Lett. 75, 2444 (1999)]. The variation in the valence-band edge is herein caused by the variation in Al content in the plurality of semiconductor layers. Acceptors may be ionized where the band edge is far below the Fermi energy and the resulting holes may accumulate where the band edge is close to the Fermi level. The valence-band edge may herein vary in a direction perpendicular to the layers of the plurality of semiconductor layers. As a consequence of the variation in the valence-band edge, the hole concentration may also vary. However, the average hole concentration may be higher than in a bulk film wherein the valence-band edge does not vary. It should be understood that the variation in the valence-band edge may be due to a varying bandgap in the plurality of semiconductor layers as well as polarization effects due to band bending.

The plurality of semiconductor layers may also enhance the hole mobility, as further described by Kozodoy et al. [Appl. Phys. Lett. 75, 2444-2446 (1999)].

There are various ways to implement a plurality of semiconductor layers which is configured such that an aluminum content changes between each consecutive layer such that every second layer has a lower aluminum content than the neighboring mutually opposite layers thereof. A few examples are given below.

In a first example, the plurality of semiconductor layers comprises a sequence of layers wherein even numbered layers have a low aluminum content and odd numbered layers have a high aluminum content, or vice versa.

In a second example, the plurality of semiconductor layers comprises a sequence of layers wherein each layer is associated with a number n, wherein n represents a position in the sequence of layers, wherein layers with even number n have a lower aluminum content than layer number n-1 and layer number n+1.

In a third example, the plurality of semiconductor layers comprises a sequence of layers wherein each layer is associated with a number n, wherein n represents a position in the sequence of layers, wherein layers with odd number n have a lower aluminum content than layer number n-1 and layer number n+1.

As used herein, the term "memory cell" should be construed as a cell that stores at least one bit of binary information. The charge stored in the charge trap of the memory cell may represent the stored binary information.

For example, the memory cell may be configured to store one bit. Herein, the absence of charge in the charge trap, e.g. the charge trap storing charge below a threshold value, may represent 1. The presence of charge in the charge trap, e.g. the charge trap storing charge above a threshold value, may represent 0.

As the charge trap of the memory cell is configured to store a charge and to control a threshold voltage of the transistor of the memory cell by said stored charge, the memory cell may be read out by applying a voltage between the source pillar segment and the drain pillar segment. The threshold voltage, at which the transistor turns on, thereby indicates which bit value is stored. The charge trap of the memory cell may be arranged in the vicinity of the body pillar segment of the transistor of the memory cell. Thus, charge stored in the charge trap may effectively control the threshold voltage of the transistor. The charge trap of the memory cell may e.g. be arranged on a lateral side of the body pillar segment of the transistor of the memory cell.

The memory device provides high storage capacity as the source, body, and drain of the transistor are respective pillar segments along an axial direction of the pillar. Thus, source, body, and drain may be stacked on top of each other and thereby have a small footprint on the substrate.

A further improvement in storage capacity may be achieved if a plurality of memory cells is associated with the pillar. Thus, memory cells may be stacked in multiple layers such that a large memory capacity may be achieved within a small area on the substrate. It should be understood that facilitating a large memory capacity within a small area may ensure a low-cost memory device as more memory cells may be produced from the same substrate.

A plurality of memory cells associated with the pillar may be implemented by stacking transistors on top of each other along the height of the pillar. It should be understood that pillar segments may be shared by adjacent transistors. For example, a memory device comprising a pillar with two NPN transistors may be implemented by the following doping sequence: NPNPN. Herein, the n-doped pillar segment in the middle may function both as a drain pillar segment for the first transistor and a source pillar segment for the second transistor. In the vicinity of each body pillar segment there may be a charge trap. In the above example of the memory device comprising a pillar with two NPN transistors there may be a charge trap in the vicinity of each of the two p-doped segments, e.g. on a lateral side of each of the two p-doped segments.

As used herein, the term "pillar" should be construed as any elongated member wherein the axial direction of the pillar is the main direction of elongation. The pillar may be standing on a substrate wherein the axial direction of the pillar is perpendicular to the substrate. The pillar may be etched out of a layer of semiconductor material or etched out of a plurality of layers of semiconductor material. The semiconductor material may herein be single crystalline semiconductor material. The pillar may have a diameter smaller than 1 µm, such as e.g. between 5 nm and 500 nm. The pillar may advantageously be a nanowire. The nanowire may have a diameter smaller than 100 nm, such as e.g. between 5 and 100 nm or between 10 and 50 nm. A small diameter of the pillar may facilitate a small footprint. Further, a small diameter, such as a diameter below 100 nm, may provide a high charge carrier mobility through quantum confinement effects. This may provide fast read and write speeds of the memory device.

A bottom part of the pillar may be connected to the substrate. The pillar may be embedded in supporting and/or electrically insulating material. Alternatively, the pillar may be free standing on the substrate without being embedded. One or more electrical gates may be arranged along the height of the pillar. For example, a control gate may be arranged in the vicinity of each body pillar segment, e.g. at a lateral side of each body pillar segment.

A bottom and a top pillar segment may be electrically connected respectively. The electrical connections at the bottom and top pillar segment may be configured to drive a current through the pillar from the bottom to the top pillar segment or vice versa.

The memory device may be configured such that, for each of the at least one memory cells:
the memory cell comprises a control gate arranged at a lateral side of the pillar, the control gate being configured to control a current through the body pillar segment of the transistor by a voltage of the control gate relative to the threshold voltage of the transistor; and
the charge trap of the memory cell is arranged between the control gate and the body pillar segment of the transistor of the memory cell, the charge trap comprising a first oxide layer, a charge trapping layer, and a second oxide layer, wherein the first oxide layer separates the charge trapping layer from the body pillar segment and the second oxide layer separates the charge trapping layer from the control gate, wherein the charge trapping layer comprises a dielectric layer and/or a conductive layer.

As previously mentioned, the control gate of the memory cell may be arranged in the vicinity of the body pillar segment of the transistor of the memory cell, e.g. at a lateral side of said body pillar segment. The control gate may be electrically separated from the body pillar segment by the first and second oxide layer. A voltage of the control gate may induce an electric field in the body pillar segment and thereby control a current through the body pillar segment. When the voltage of the control gate is above a threshold voltage of the transistor of the memory cell, the transistor may be turned on, allowing current to pass. When the voltage of the control gate is below a threshold voltage of the transistor of the memory cell, the transistor may be turned off, not allowing current to pass. As previously mentioned, the charge trap of the memory cell is configured to store a charge and to control the threshold voltage of the transistor of the memory cell by said stored charge. When the charge trap of the memory cell is arranged between the control gate and the body pillar segment of the transistor of the memory cell the charge in the charge trap may screen the electric field from the control gate, and thus change the threshold voltage.

In accordance with the above, the first oxide layer may be seen as a tunnel oxide layer and the second oxide layer may be seen as a gate oxide layer.

The following example describes how a value may be read from the memory cell. When no charge is stored in the charge trap, the threshold voltage of the transistor may be V_{T1}. When charge is stored in the charge trap the threshold voltage of the transistor may be V_{T2}, wherein V_{T2}> V_{T1}. Thus, when charge is stored in the charge trap, a higher voltage on the control gate is needed to turn the transistor on. The control gate voltage may then be set to an intermediate voltage, the intermediate voltage being between V_{T2} and V_{T1}. If then the transistor conducts, at said intermediate voltage, the threshold voltage can be assumed to be V_{T1}, indicating that no charge is stored in the charge trap. Thus, the absence of charge in the charge trap, may be indicated by a current through the transistor, which may represent a binary value of 1. Similarly, if then the transistor does not conduct, at said intermediate voltage, the threshold voltage can be assumed to be V_{T2}, indicating that charge is stored in the charge trap. Thus, the presence of charge in the charge trap, may be indicated by an absence of current through the transistor, which may represent a binary value of 0.

The following example describes how a value may be written to the memory cell or erased from the memory cell. Writing and erasing may be performed by tunneling charges through the first oxide layer into or out of the charge trapping layer. The tunneling process may be Fowler-Nordheim tunneling. Writing may alternatively be performed by hot-electron injection.

For each of the at least one memory cells, the first oxide layer and/or the second oxide layer of the charge trap of the memory cell may comprise Al₂O₃. An oxide layer of Al₂O₃ may be advantageous as it can be provided by atomic layer deposition without any parasitic trap states at the interface.

As described, the charge trapping layer may comprise a dielectric layer, e.g. silicon nitride. A dielectric layer may be advantageous as the dielectric layer of one memory cell may not need to be electrically isolated from the dielectric layer of another memory cell. Charges may be stored in localized traps in the dielectric layer such that they cannot move from one memory cell to another even if the same dielectric layer is used for both memory cells. Thus, manufacturing may be simplified. The dielectric layer may comprise high-k dielectric material. For example, for each of the at least one memory cells, the charge trapping layer of the charge trap of the memory cell may comprise a high-k dielectric material, such as Y₂O₃, TiO₂, HfO₂, ZrO₂, or La₂O₃. The dielectric layer may be deposited e.g. through atomic layer deposition.

As described, the charge trapping layer may comprise a conductive layer. The conductive layer comprises electrically conductive material such as metal or doped semiconductor material, e.g. degeneratively doped semiconductor material. A conductive layer may have the advantage that it is quite insensitive to trap related reliability issues. When using a conductive layer it is unlikely that the memory cell gets stuck in a permanent logic state (e.g. always 1) due to insufficient trap reliability. When a conductive layer is used the conductive layer of one memory cell may be electrically isolated from the conductive layer of other memory cells. The conductive layer may be deposited e.g. through atomic layer deposition.

It should be understood that the charge trapping layer may comprise both a dielectric and a conductive layer. Such a charge trapping layer may combine advantages of the two materials.

For each of the at least one memory cells, the transistor of the memory cell may comprise a repetition of a pair of semiconductor layers, wherein each pair of semiconductor layers comprises
a low Al content layer, having an Al content below 10%; and
a high Al content layer, having an Al content above 15%.

Thus, the low Al content layer may be a layer of AlₓGa₁₋ₓN, wherein x<0.1. Similarly, the high Al content layer may be a layer of AlₓGa₁₋ₓN, wherein x>0.15. It is preferred that all low Al content layers have the same composition. For example, all low Al content layers may have an Al content of zero, i.e. they comprise GaN, i.e. x=0. It is preferred that all high Al content layers have the same composition and that they have an Al content between 20% and 40%, i.e. they comprise a material ranging from Al_{0.2}Ga_{0.8}N to Al_{0.4}Ga_{0.6}N, i.e. 0.2<x<0.4. An example of a plurality of semiconductor layers comprising four layers may be Al_{0.2}Ga_{0.8}N/GaN/Al_{0.2}Ga_{0.8}N/GaN or Al_{0.3}Ga_{0.7}N/GaN/Al_{0.3}Ga_{0.7}N/GaN.

As an alternative, each pair of semiconductor layers may comprise a low and high Al content layer but all low Al content layers may not necessarily have the same Al content. Similarly, all high Al content layers may not necessarily have the same Al content. Thus, the plurality of semiconductor layers may be e.g. Al_{0.2}Ga_{0.8}N/ Al_{0.05}Ga_{0.95}N/ Al_{0.16}Ga_{0.84}N/ GaN or Al_{0.3}Ga_{0.7}N/ Al_{0.09}Ga_{0.91}N/ Al_{0.22}Ga_{0.78}N/ Al_{0.02}Ga_{0.98}N/ Al_{0.2}Ga_{0.8}N/ Al_{0.07}Ga_{0.93}N.

Layers with a low Al content may, as a first approximation, have a smaller bandgap than layers with a high Al content. This may give rise to a variation in the valence band edge. However, polarization effects and/or strain effects between the low and high Al content layers, may modify the variation in the valence band edge. For example, local energy minima and local energy maxima in the varying valence band edge may lie at interfaces between high Al content layers and low Al content layers. To exemplify, assuming that the surface of the crystal is Ga face (this may be the case when MOCVD is used to initiate growth on sapphire) going from the substrate and upwards through the plurality of semiconductor layers local energy minima may appear at interfaces in the conduction band where a low Al content layer transitions into a high Al content layer (let us label this region A) and local energy maxima may appear at interfaces where a high Al content layer transitions into a low Al content layer (let us label this region B). The above description is in analogy with the description on page 2445 of [Appl. Phys. Lett. 75, 2444-2446 (1999)] which is hereby included by reference.

It should be noted that when this text refers to the plurality of semiconductor layers being p-doped it can be construed as the plurality of semiconductor layers being p-doped in A regions but not in B regions. Such doping may give rise to the highest hole mobilities. However, it may of course also be construed as the plurality of semiconductor layers being p-doped throughout the layers of the plurality of semiconductor layers.

For each of the at least one memory cells, each layer, of the plurality of semiconductor layers of the at least one p-doped pillar segment of the transistor, may have a thickness between 3 nm and 10 nm. The layers may all have the same thickness, e.g. all layers having a thickness of 3 nm, all layers having a thickness of 6 nm, or all layers having a thickness of 10 nm. Alternatively, the plurality of semiconductor layers may comprise layers of different thicknesses. For example, all low Al content layers may have a thickness between 3 nm and 10 nm and all high Al content layers may have a thickness between 3 nm and 10 nm, wherein the thickness of the low Al content layers is different from the thickness of the high Al content layers. For example, each pair of semiconductor layers may comprise e.g. a 6 nm thick low Al content layer and a 5 nm thick high Al content layer.

In the 3-10 nm thickness range the enhancement of the p-doping may be most efficient. For example, the polarization effects and/or strain effects between the low and high Al content layers may be most effective in said thickness range.

It should be understood that the memory device may comprise a plurality of pillars. For example, the memory device may comprise a first and a second pillar, each of the first and second pillar having at least one memory cell associated with said pillar, wherein a memory cell of the first pillar and a memory cell of the second pillar share a common control gate, the common control gate being configured to simultaneously control a current through the body pillar segment of the transistor of the memory cell of the first pillar and a current through the body pillar segment of the transistor of the memory cell of the second pillar, by a voltage of the common control gate.

Thus, the common control gate may be a word line of the memory device. The common control gate enables simultaneous read out from several memory cells.

According to a second aspect, there is provided use of the memory device according to the first aspect for analog to digital conversion, wherein conversion rules for the analog to digital conversion are stored in the memory device.

The conversion rules may be a look-up table stored in the memory device, wherein the look-up table relates an amplitude of an incoming analog signal to a digital value which said amplitude shall be converted into.

The conversion rules may be an algorithm stored in the memory device, wherein the algorithm relates an amplitude of an incoming analog signal to a digital value which said amplitude shall be converted into. The algorithm may be a self-calibration algorithm.

The use of a memory device according to the first aspect may facilitate accurate analog to digital conversion. Further, an analog to digital converter may comprise a memory device according to the first aspect, wherein conversion rules for the analog to digital conversion are stored in the memory device. Thus, an analog to digital converter comprising GaN based material may advantageously comprise a memory device according to the first aspect.

Other uses of the memory device may include use in a field-programmable gate array (FPGA), e.g. in a FPGA for high-power or high temperature use.

According to a second aspect, there is provided a method for producing a memory device, the method comprising
depositing semiconductor layers on a substrate, the semiconductor layers being stacked in a stacking direction, whereby a semiconductor structure is formed out of the deposited semiconductor layers;
etching the semiconductor structure to form a pillar, the pillar having an axial direction in the stacking direction;
forming a transistor in the pillar, the transistor comprising a source, a body, and a drain, wherein the source, body, and drain are respective pillar segments along the axial direction of the pillar, wherein a source pillar segment and a drain pillar segment are separated by a body pillar segment, wherein the transistor is either
   - a NPN transistor, wherein the source pillar segment is n-doped, the body pillar segment is p-doped, and the drain pillar segment is n-doped; or

   - a PNP transistor, wherein the source pillar segment is p-doped, the body pillar segment is n-doped, and the drain pillar segment is p-doped;
wherein at least one p-doped pillar segment of the transistor comprises a plurality of semiconductor layers, of the deposited semiconductor layers, stacked in the axial direction of the pillar, wherein layers of the plurality of semiconductor layers of the p-doped pillar segment are made of AIGaN or GaN, and wherein the plurality of semiconductor layers of the p-doped pillar segment is configured such that an aluminum content changes between each consecutive layer such that every second layer has a lower aluminum content than the neighboring mutually opposite layers thereof;
forming a charge trap configured to store a charge and to control a threshold voltage of the transistor by said stored charge;
wherein the transistor and the charge trap are parts of a memory cell of the memory device.

The method facilitates simple production of memory devices, especially in comparison to production of conventional 3D flash architectures. A conventional 3D flash architecture device may be produced by etching channel holes in a supporting material and then depositing channel material into said holes. It is a realization that production of conventional 3D flash architectures has several drawbacks which the current method overcomes.

It is a realization that, in the production of conventional 3D flash architectures, the dry etch for channel holes is a challenging step, wherein classical dry etch chemistries are used to their limits.

Conventional 3D flash architectures may require depositing alternating layer stacks and then etching those stacked layers with extreme precision. Staircase etch for contact landing, hard mask etch, gate trench etch, channel hole etch and staircase contact etch are the main critical etches may be required to manufacture conventional 3D flash devices. It is a realization that plasma etching processes involved in the fabrication of conventional 3D flash devices are becoming increasingly challenging. The staircase etch, which requires lateral resist mask etch followed by vertical stacked layer etch, repeated in multiple the lateral/vertical etch cycles, to form staircase shaped contact landing pads, offers unique challenges in lateral to vertical etch rate control of resist mask, resist mask shape control, selectivity control of the stacked layer etch, staircase step width control and step width uniformity control. Hardmask open, gate trench etch, channel hole etch, and staircase contact etch create significant challenges for etching, especially of high aspect ratio (HAR) features ranging in aspect ratio from 30:1 to >80:1. Furthermore, etching through the HAR alternating layer stacks intensifies the demands on the etch process, which must be capable of etching distortion free, vertical profiles free of bending, faceting and feature clogging. Additionally, smooth sidewall transitions in the alternating stack, and very high selectivity to the tiny pad are required, especially for the staircase contact etch application, which combines extreme simultaneous multi-level etch at aspect ratios ranging from 30:1 to >80:1 along with extremely high selectivity for negligible loss of the underlying contacted material.

The current method may be seen as a bottom-up production method, in contrast to conventional top-down production of conventional 3D flash architectures.

It should be understood that, according to the method, more than one pillar may be etched. A plurality of pillars, e.g. an array of pillars, may be etched.

The method may further comprise lithographically defining a lateral size and a position of the pillar by imprint lithography. The imprint lithography may be nanoimprint lithography. The method may comprise lithographically defining an array of pillars by imprint lithography. Imprint lithography is a cheap and simple way of patterning large areas, e.g. an entire wafer.

The charge trap may be formed by depositing, on a lateral side of the pillar, a first oxide layer, a charge trapping layer, a second oxide layer, and a control gate,
wherein the first oxide layer separates the charge trapping layer from the body pillar segment, and the second oxide layer separates the charge trapping layer from the control gate;
wherein the charge trapping layer comprises a dielectric layer and/or a conductive layer;
wherein the control gate is configured to control a current through the body pillar segment of the transistor, by a voltage of the control gate relative to the threshold voltage of the transistor.

As previously described, the first oxide layer may be seen as a tunnel oxide layer and the second oxide layer may be seen as a gate oxide layer.

By depositing layers on a lateral side of the pillar, a high-quality charge trap may be formed. The layer thickness is accurately controlled by the deposition. Thus, tunnel oxide layers, charge trapping layers, and gate oxide layers have homogenous thicknesses from pillar to pillar and from device to device.

The method may comprise etching the semiconductor structure to form a first and a second pillar, each of the first and second pillar having at least one memory cell associated with said pillar, the method further comprising:
forming a common control gate, the common control gate being shared between a memory cell of the first pillar and a memory cell of the second pillar, the common control gate being configured to simultaneously control a current through the body pillar segment of the transistor of the memory cell of the first pillar and a current through the body pillar segment of the transistor of the memory cell of the second pillar, by a voltage of the common control gate, wherein the common control gate is formed after etching the semiconductor structure to form the first and the second pillar.

Thus, the common control gate may be a word line of the memory device. The common control gate enables simultaneous read out from several memory cells. Forming the common control gate after etching the semiconductor structure to form the first and the second pillar facilitates a stable production process. In other words, forming word lines around pillars facilitates a stable production process. In contrast, etching holes between word lines to form channels in the holes may create a fragile structure, much like a "house of cards".

According to the method the first oxide layer, the charge trapping layer, and the second oxide layer may be deposited by one or more conformal depositing techniques, such as atomic-layer deposition, and/or chemical vapor deposition, and/or plasma-enhanced chemical vapor deposition.

Said conformal depositing technique may be a technique configured to deposit layers with little or no regard to direction.

The control gate may be deposited by a directional depositing technique, such as evaporation or sputtering. Said directional depositing technique may be a technique configured to deposit layers mainly in one direction, e.g. a direction defined by a straight path between the heated boat of an evaporator and the target area of the evaporator.

It should be noted that a memory device according to the first aspect, the use of a memory device according to the second aspect, and a method for producing a memory device according to the third aspect, may all have the same advantages, or similar advantages.

### BRIEF DESCRIPTION OF THE DRAWINGS

The above, as well as additional objects, features and advantages of the present inventive concept, will be better understood through the following illustrative and non-limiting detailed description, with reference to the appended drawings. In the drawings like reference numerals will be used for like elements unless stated otherwise.
Fig. 1 illustrates a cross-sectional view of a memory device
Fig. 2 illustrates a cross-sectional view of a memory device
Fig. 3 illustrates a memory device, seen in a cross-sectional view from the side
Fig. 4 illustrates a memory device, seen in a cross-sectional view from above
Fig. 5 illustrates a memory device, seen in a top view
Fig. 6 illustrates a flow chart of a method

### DETAILED DESCRIPTION

In cooperation with attached drawings, the technical contents and detailed description of the present invention are described thereinafter according to preferable embodiments, being not used to limit the claimed scope. This invention may be embodied in many different forms and should not be construed as limited to the embodiments set forth herein; rather, these embodiments are provided for thoroughness and completeness, and fully convey the scope of the invention to the skilled person.

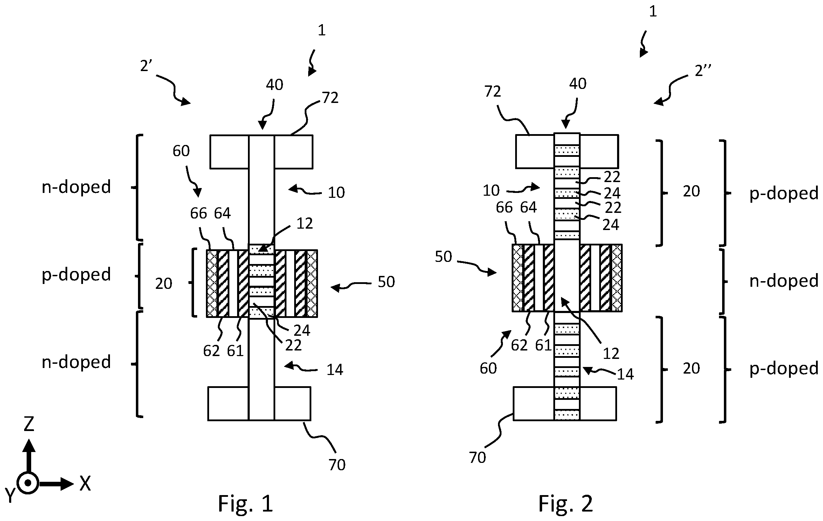

Figs. 1 and 2 respectively illustrate a cross-sectional view of a memory device 1. The illustrated memory devices 1 each comprises a pillar 40 of semiconductor material. Each of the illustrated pillars 40 have an axial direction. In general, the pillars 40 of the memory devices 1 are epitaxially grown on top of a substrate 90 (not shown in Figs. 1-2). The pillars 40 then generally have an axial direction normal to the substrate 90. In the following, the memory devices 1 will be described as having a pillar 40 on top of a substrate 90 wherein the axial direction of the pillar 40 is normal to the substrate 90. In the coordinate system of the figures associated with this description the axial direction of the pillar 40 is the Z direction. Consequently, a lateral direction with respect to the axial direction of the pillar 40 may be seen as a direction in the plane spanned by the X and Y directions in the coordinate system of the figures associated with this description.

The pillar 40 may have a diameter smaller than 1 µm, e.g. between 5 nm and 500 nm, or between 5 nm and 100 nm, or between 10 nm and 50 nm. The pillar 40 is made of semiconductor material, such as GaN and AIGaN.

The memory devices 1 of Figs. 1 and 2 each comprises one single memory cell 50, wherein the memory cell 50 comprises a charge trap 60 and a transistor 2. In Fig. 1 the transistor 2 is a NPN transistor 2' and in Fig. 2 the transistor 2 is a PNP transistor 2".

As illustrated in Figs. 1 and 2, each pillar 40 is doped to form the transistor 2 of the memory cell 50. The transistor 2 comprising a source pillar segment 10, followed by a body pillar segment 12, followed by a drain pillar segment 14. Fig. 1 illustrates a NPN transistor 2' wherein the source pillar segment 10 is n-doped, the body pillar segment 12 is p-doped, and the drain pillar segment 14 is n-doped. Fig. 2 illustrates a PNP transistor 2" wherein the source pillar segment 10 is p-doped, the body pillar segment 12 is n-doped, and the drain pillar segment 14 is p-doped.

The p-doped body pillar segment 12 of the NPN transistor 2' of Fig. 1 comprises a plurality of semiconductor layers 20 stacked in the axial direction of the pillar 40, wherein layers of the plurality of semiconductor layers 20 are made of AIGaN or GaN, and wherein the plurality of semiconductor layers 20 is configured such that an aluminum content changes between each consecutive layer such that every second layer has a lower aluminum content than the neighboring mutually opposite layers thereof.

Analogously, the p-doped source pillar segment 10 and drain pillar segment 14 of the PNP transistor 2" of Fig. 2 comprises a plurality of semiconductor layers 20 stacked in the axial direction of the pillar 40, wherein layers of the plurality of semiconductor layers 20 are made of AIGaN or GaN, and wherein the plurality of semiconductor layers 20 is configured such that an aluminum content changes between each consecutive layer such that every second layer has a lower aluminum content than the neighboring mutually opposite layers thereof.

The p-doped pillar segment comprising a plurality of semiconductor layers 20 may comprise a repetition of a pair of semiconductor layers, wherein each pair of semiconductor layers comprises a low Al content layer 22 and a high Al content layer 24. Thus, every second layer of the plurality of semiconductor layers 20 may be a low Al content layer 22, wherein the high Al content layers 24 are arranged between the low Al content layers 22. Low Al content layers 22 may have an Al content below 10% and high Al content layers 24 may have an Al content above 15%. As an example, the plurality of semiconductor layers 20 may comprise a sequence of layers wherein even numbered layers are low Al content layers 22 and odd numbered are high Al content layers 24, or vice versa. Low Al content layers 22 may be GaN layers and high Al content layers 24 may be AlGaN layers, e.g. Al_{0.2}Ga_{0.8}N layers or Al_{0.4}Ga_{0.6}N layers.

Further, each layer of the plurality of semiconductor layers 20 of a p-doped pillar segment of the transistor 2 may have a thickness between 3 nm and 10 nm.

Each memory cell 50 in Figs. 1 and 2 further comprises a charge trap 60 configured to store a charge and to control a threshold voltage of the transistor 2. The illustrated charge trap 60 is arranged in the vicinity of the body pillar segment 12 of the transistor 2. Thus, a charge in the charge trap 60 affects the threshold voltage of the transistor 2.

Each memory cell 50 in Figs. 1 and 2 further comprises a control gate 66 arranged at a lateral side of the pillar 40, the control gate 66 being configured to control a current through the body pillar segment 12 of the transistor 2 by a voltage of the control gate 66 relative to the threshold voltage of the transistor 2.

In Figs. 1 and 2, the charge trap 60 is arranged between the control gate 66 and the body pillar segment 12 of the transistor 2 of the memory cell 50. Each illustrated charge trap 60 comprises a first oxide layer 61, a charge trapping layer 64, and a second oxide layer 62, wherein the first oxide layer 61 separates the charge trapping layer 64 from the body pillar segment 12 and the second oxide layer 62 separates the charge trapping layer 64 from the control gate 66. It should be noted that Fig. 1 and 2 are cross sectional views and that the first oxide layer 61, the charge trapping layer 64, the second oxide layer 62, and the control gate 66 may extend around the circumference of the pillar 40.

The charge trapping layer 64 may comprise a dielectric layer and/or a conductive layer.

For example, the charge trapping layer 64 may comprise a dielectric layer of Si₃N₄. The charge trapping layer 64 may comprise a dielectric layer of high-k dielectric material, such as Y₂O₃, TiO₂, HfO₂,ZrO₂, or La₂O₃.

Alternatively, or additionally, the charge trapping layer 64 may comprise a conductive layer, such as a metal or doped semiconductor material, e.g. degeneratively doped Si.

The first oxide layer 61 and/or the second oxide layer 62 may comprise Al₂O₃. Alternatively, or additionally, other oxides may be used, e.g. silicon dioxide.

A layer sequence which advantageously may be used to form a charge trap 60 and a control gate 66 will now be given. Herein, a 3 nm thick layer of Al₂O₃ is arranged on the lateral sides of the pillar 40, around the circumference of the pillar 40, and in the vicinity of the body pillar segment 12 of the transistor 2 of the memory cell 50, said layer forming the first oxide layer 61. A 10 nm thick layer of HfO₂ is arranged on the first oxide layer 61, thereby forming the charge trapping layer 64. A 15 nm thick layer of Al₂O₃ is arranged on the charge trapping layer 64, thereby forming the second oxide layer 62. Finally, a 100 nm thick layer of AlCu is arranged on the second oxide layer 62, thereby forming the control gate 66.

In Figs. 1 and 2 each pillar 40 has a bottom contact 70 and a top contact 72. Thus, a current may be driven through the pillar from the top contact 72, through the source pillar segment 10, through the body pillar segment 12, through the drain pillar segment 14, to the bottom contact 70.

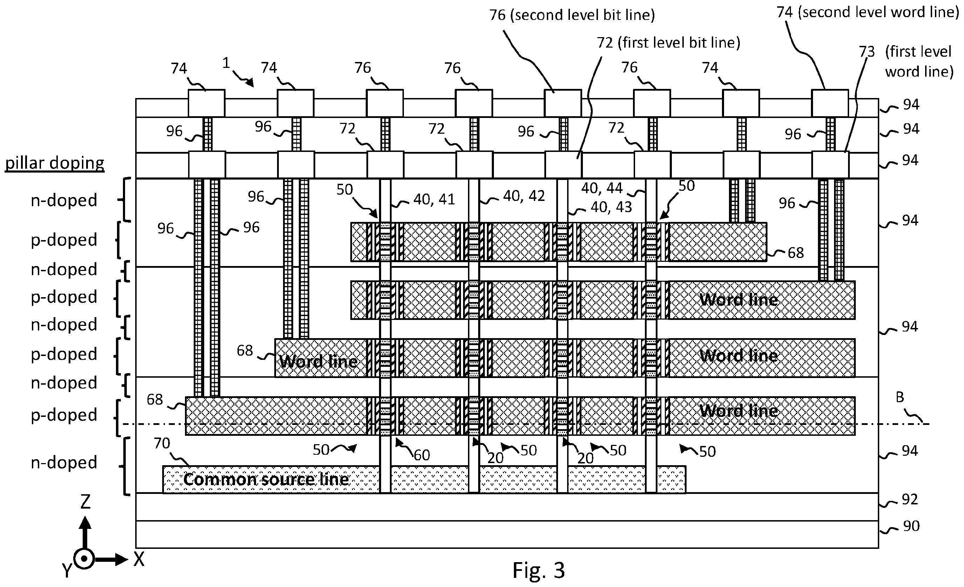

The memory device 1 may comprise more than one pillar 40. Further, there may be more than one memory cell 50 associated with each pillar 40 of the memory device 1. Figs. 3-5 illustrate a memory device 1 comprising a four by four array of pillars 40, wherein each pillar 40 is associated with four memory cells 50, arranged at four different vertical heights of the pillar. It should be understood that the figures are schematic. There may be more than four memory cells 50 associated with each pillar 40. There may be e.g. 32, 64, or 128 memory cells 50 associated with each pillar 40. The memory cells 50 associated with each pillar 40 may be seen as forming a string.

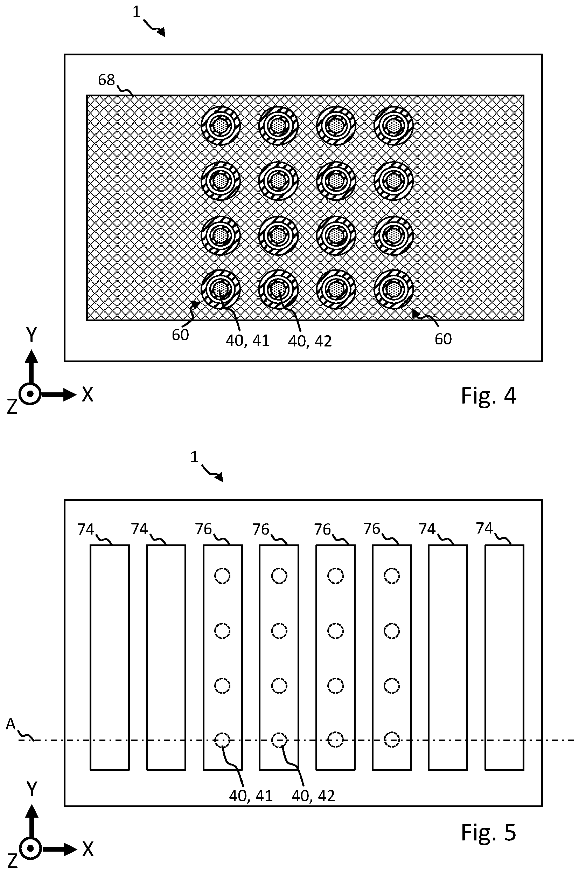

Fig. 5 illustrates a top view of the memory device 1. Fig. 3 illustrates cross sectional view seen from the side, wherein the cross section is a cross section along line A in Fig. 5. Fig. 4 illustrates cross sectional view seen from above, wherein the cross section is a cross section along line B in Fig. 3.

In Fig. 3, four pillars 40 are seen in cross section, wherein the pillars may be termed first 41, second 42, third 43, and fourth 44 pillar. As illustrated, each pillar 40 is doped NPNPNPNPN from bottom to top, thereby forming four NPN transistors 2'. Each NPN transistor 2' is associated with a charge trap 60 and together they form parts of a memory cell 50 in analogy to the memory cell 50 described in conjunction with Fig. 1. It should be understood that for a memory device 1 comprising a plurality of pillars 40, the pillars 40 may be doped to form PNP transistors 2" instead of the illustrated NPN transistors 2'.

In the illustrations, memory cells 50 at the same vertical height share a common control gate 68. Thus, reading, writing, and erasing may be performed simultaneously for all memory cells 50 sharing a common control gate 68 by applying a voltage on said common control gate 68. The common control gate 68 may connect all memory cells 50 of the array of pillars at a certain vertical height, as illustrated in Fig. 4. Alternatively, the common control gate 68 may connect memory cells 50 within the same row of the array of pillars at certain vertical height. The common control gate 68 may connect to all memory cells 50 at the same position in the strings.

In Fig. 3, the first 41, second 42, third 43, and fourth 44 pillar have separate top contacts 72 while they share a common bottom contact 70. Alternatively, the first 41, second 42, third 43, and fourth 44 pillar may also have separate bottom contacts 70.

When the memory device 1 comprises more than one pillar 40 the following terminology may be used:
The top contacts 72 may be called bit lines. Further, there may be several levels of bit lines. As illustrated in Fig. 3 the top contacts 72 may be seen as a first level bit line 72. The first level bit line 72 may be electrically connected to a second level bit line 76, via a vertical connector 96. The second level bit line 76 being arranged above the first level bit line 72.

The common control gates 68 may be called word lines. Further, there may be several levels of word lines. As illustrated in Fig. 3, a common control gate 68 may be electrically connected to a first level word line 73 via a vertical connector 96. The first level word line 73 may be electrically connected to a second level word line 74 via a vertical connector 96. The second level word line 74 being arranged above the first level word line 73.

The common bottom contact 70 may be called common source line.

According to the above, whenever this text mentions top contact 72 it may be interpreted as bit line, whenever this text mentions common control gate 68 it may be interpreted as word line, whenever this text mentions common bottom contact 70 it may be interpreted as common source line.

Common control gates 68, also known as word lines, may comprise metal, e.g. an alloy of a Ni/Al/NiV stack i.e. a Ni, Al, NiV layer structure. Bottom contacts 70, also known as common source lines, may comprise metal, e.g. an alloy of a Ni/Al/NiV stack i.e. a Ni, Al, NiV layer structure. Top contacts 72, also known as first level bit lines 72, and second level bit lines 76, may comprise metal, e.g. AlCu. First level word lines 73, and second level word lines 74 may comprise metal, e.g. AlCu. Vertical connectors 96 may comprise metal, e.g. TiN.

As illustrated in Fig. 3, the pillars 40 may be arranged on a base layer 92 which in turn is arranged on a substrate 90. The substrate 90 may be a silicon substrate. The base layer 92 may comprise a AlN layer on top of the substrate 90 followed by an AlGaN or GaN layer. The AlN layer on top of the substrate 90 may be sputtered AlN. The AlN layer may be patterned, e.g. corrugated. The AlN layer may thus mitigate dislocation formation in subsequent layers.

As illustrated in Fig. 3, the pillars 40 may be embedded in one or more embedding layers 94. The embedding layers 94 may be high-frequency deposited plasma-enhanced chemical vapor deposition oxide (HDPOX) or low-frequency deposited plasma-enhanced chemical vapor deposition oxide (LDPOX), or PSG or any combination thereof.

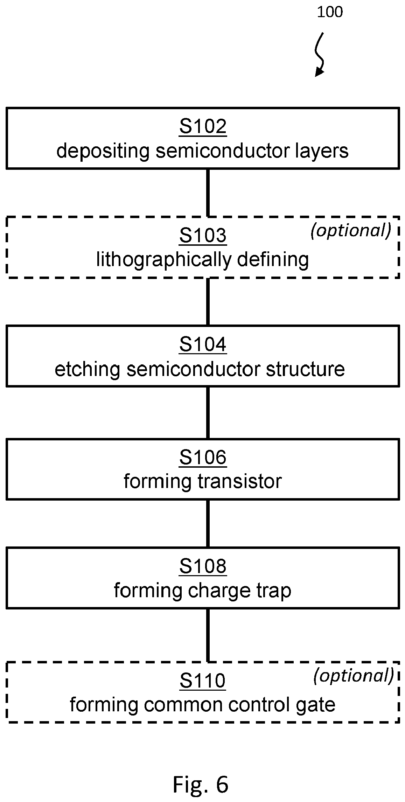

In the following a method 100 for producing a memory device 1 is described. Fig. 6 illustrates a flow chart of the method 100. It should be understood that the steps of the method 100 do not necessarily need to be performed in the order illustrated.

According to the method 100 semiconductor layers are deposited S102 on a substrate 90. For example, AlN may be sputtered on a silicon substrate 90. Subsequent layers may then be epitaxially grown, e.g. by metalorganic vapor-phase epitaxy. After the AlN layer, one or more AlGaN layers may be grown. The Al content may be gradually reduced to zero until pure GaN is achieved. The layers from the AlN layer to said pure GaN may be seen as a base layer 92. On top of the base layer 92 a sequence of layers with alternating doping may be grown, for example NPNPNPNPN from bottom to top to produce the Fig. 3 memory device 1. The n-doped layers may be e.g. GaN to produce the Fig. 3 memory device 1. One or more of the p-doped layers comprises a plurality of semiconductor layers 20, wherein layers of the plurality of semiconductor layers 20 are made of AlGaN or GaN, and wherein the plurality of semiconductor layers 20 is configured such that an aluminum content changes between each consecutive layer such that every second layer has a lower aluminum content than the neighboring mutually opposite layers thereof. For example, to produce the Fig. 3 memory device 1 each p-doped layer may comprise the following plurality of layers 20:

Al_{0.2}Ga_{0.8}N/GaN/Al_{0.2}Ga_{0.8}N/GaN/Al_{0.2}Ga_{0.8}N/GaN/Al_{0.2}Ga_{0.8}N

According to the method 100 the deposited S102 layers form a semiconductor structure which is subsequently etched S104 to form one or more pillars 40.

Prior to etching S104, lateral sizes and positions of the pillars 40 may optionally be lithographically defined by imprint lithography. Thus, a top surface of the semiconductor structure may be coated by a polymer film and a stamp may selectively remove parts of the polymer film to expose the semiconductor structure which may then be etched S104.

If, as described above, the semiconductor layers of the semiconductor structure are doped during epitaxial growth, the pillars 40 formed through etching S104 will now form pillar segments of alternating doping. If control gates 66 are arranged in the vicinity of p-doped pillar segments, NPN transistors 2' may be formed S106. Similarly, if control gates 66 are arranged in the vicinity of n-doped pillar segments, PNP transistors 2" may be formed S106. As an alternative to doping during epitaxial growth, the pillars 40 may be doped after epitaxial growth.

According to the method 100, a charge trap 60 configured to store a charge and to control a threshold voltage of the transistor 2 by said stored charge is formed S108. This may be done by depositing on the lateral sides of the pillars 40, a first oxide layer 61, followed by a charge trapping layer 64, followed by a second oxide layer 62. Said layers may be deposited by one or more conformal depositing techniques, such as atomic-layer deposition, and/or chemical vapor deposition, and/or plasma-enhanced chemical vapor deposition.

The first oxide layer 61 and the second oxide layer 62 may be Al₂O₃. The charge trapping layer 64 may be e.g. Y₂O₃, TiO₂, HfO₂,ZrO₂, La₂O₃, metal or a doped semiconductor material.

After conformally coating the pillars 40 with the first oxide layer 61, the charge trapping layer 64 and the second oxide layer 62, a control gate 66 may be formed, e.g. a common control gate 68. An embedding layer 94 may be deposited up to the lowest body pillar segment 12. The common control gate 68 may then be formed S110 by depositing metal by a directional depositing technique, such as evaporation or sputtering. Said metal may be deposited in a direction along the axial direction of the pillars 40. The metal may form a layer with a normal in the axial direction of the pillars 40.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A memory device (1) comprising a pillar (40) of semiconductor material and at least one memory cell (50) associated with the pillar (40), wherein each of the at least one memory cells (50) comprises a charge trap (60) and a transistor (2), wherein, for each of the at least one memory cells (50):
the charge trap (60) of the memory cell (50) is configured to store a charge and to control a threshold voltage of the transistor (2) of the memory cell (50) by said stored charge; and
the transistor (2) of the memory cell (50) comprises a source, a body, and a drain, wherein the source, body, and drain are respective pillar segments along an axial direction of the pillar (40), wherein a source pillar segment (10) and a drain pillar segment (14) are separated by a body pillar segment (12), wherein the transistor (2) is either
- a NPN transistor (2'), wherein the source pillar segment (10) is n-doped, the body pillar segment (12) is p-doped, and the drain pillar segment (14) is n-doped; or
- a PNP transistor (2"), wherein the source pillar segment (10) is p-doped, the body pillar segment (12) is n-doped, and the drain pillar segment (14) is p-doped;
wherein at least one p-doped pillar segment (10, 12, 14) of the transistor (2) comprises a plurality of semiconductor layers (20) stacked in the axial direction of the pillar (40), wherein layers of the plurality of semiconductor layers (20) are made of AIGaN or GaN, and wherein the plurality of semiconductor layers (20) is configured such that an aluminum content changes between each consecutive layer such that every second layer has a lower aluminum content than the neighboring mutually opposite layers thereof.

2. The memory device (1) according to claim 1, wherein, for each of the at least one memory cells (50):
the memory cell (50) comprises a control gate (66) arranged at a lateral side of the pillar (40), the control gate (66) being configured to control a current through the body pillar segment (12) of the transistor (2) by a voltage of the control gate (66) relative to the threshold voltage of the transistor (2); and
the charge trap (60) of the memory cell (50) is arranged between the control gate (66) and the body pillar segment (12) of the transistor (2) of the memory cell (50), the charge trap (60) comprising a first oxide layer (61), a charge trapping layer (64), and a second oxide layer (62), wherein the first oxide layer (61) separates the charge trapping layer (64) from the body pillar segment (12) and the second oxide layer (62) separates the charge trapping layer (64) from the control gate (66), wherein the charge trapping layer (64) comprises a dielectric layer and/or a conductive layer.

3. The memory device (1) according to claim 2, wherein, for each of the at least one memory cells (50), the charge trapping layer (64) of the charge trap (60) of the memory cell (50) comprises a high-k dielectric material, such as Y₂O₃, TiO₂, HfO₂,ZrO₂, or La₂O₃.

4. The memory device (1) according to claim 2 or 3, wherein, for each of the at least one memory cells (50), the first oxide layer (61) and/or the second oxide layer (62) of the charge trap (60) of the memory cell (50) comprises Al₂O₃.

5. The memory device (1) according to any one of the preceding claims, wherein, for each of the at least one memory cells (50), the transistor (2) of the memory cell (50) comprises a repetition of a pair of semiconductor layers, wherein each pair of semiconductor layers comprises
a low Al content layer (22), having an Al content below 10%; and
a high Al content layer (24), having an Al content above 15%.

6. The memory device (1) according to any one of the preceding claims, wherein, for each of the at least one memory cells (50), each layer, of the plurality of semiconductor layers (20) of the at least one p-doped pillar segment (10, 12, 14) of the transistor (2), has a thickness between 3 nm and 10 nm.

7. The memory device (1) according to any one of the preceding claims, wherein the memory device (1) comprises a first (41) and a second (42) pillar, each of the first (41) and second pillar (42) having at least one memory cell (50) associated with said pillar (41, 42), wherein a memory cell (50) of the first pillar (41) and a memory cell (50) of the second pillar (42) share a common control gate (68), the common control gate (68) being configured to simultaneously control a current through the body pillar segment (12) of the transistor (2) of the memory cell (50) of the first pillar (41) and a current through the body pillar segment (12) of the transistor (2) of the memory cell (50) of the second pillar (42), by a voltage of the common control gate (68).

8. Use of the memory device (1) according to any one of the preceding claims for analog to digital conversion, wherein conversion rules for the analog to digital conversion are stored in the memory device (1).

9. A method (100) for producing a memory device (1), the method (100) comprising
depositing (S102) semiconductor layers on a substrate (90), the semiconductor layers being stacked in a stacking direction, whereby a semiconductor structure is formed out of the deposited semiconductor layers;
etching (S104) the semiconductor structure to form a pillar (40), the pillar (40) having an axial direction in the stacking direction;
forming (S106) a transistor (2) in the pillar (40), the transistor (2) comprising a source, a body, and a drain, wherein the source, body, and drain are respective pillar segments (10, 12, 14) along the axial direction of the pillar (40), wherein a source pillar segment (10) and a drain pillar segment (14) are separated by a body pillar segment (12), wherein the transistor (2) is either
- a NPN transistor (2'), wherein the source pillar segment (10) is n-doped, the body pillar segment (12) is p-doped, and the drain pillar segment (14) is n-doped; or
- a PNP transistor (2"), wherein the source pillar segment (10) is p-doped, the body pillar segment (12) is n-doped, and the drain pillar segment (14) is p-doped;
wherein at least one p-doped pillar segment (10, 12, 14) of the transistor (2) comprises a plurality of semiconductor layers (20), of the deposited semiconductor layers, stacked in the axial direction of the pillar (40), wherein layers of the plurality of semiconductor layers (20) of the p-doped pillar segment (10, 12, 14) are made of AIGaN or GaN, and wherein the plurality of semiconductor layers (20) of the p-doped pillar segment (10, 12, 14) is configured such that an aluminum content changes between each consecutive layer such that every second layer has a lower aluminum content than the neighboring mutually opposite layers thereof;
forming (S108) a charge trap (60) configured to store a charge and to control a threshold voltage of the transistor (2) by said stored charge;
wherein the transistor (2) and the charge trap (60) are parts of a memory cell (50) of the memory device (1).

10. The method (100) according to claim 9, further comprising lithographically defining (S103) a lateral size and a position of the pillar (40) by imprint lithography.

11. The method (100) according to claim 9 or 10, wherein the charge trap (60) is formed (S108) by depositing, on a lateral side of the pillar (40), a first oxide layer (61), a charge trapping layer (64), a second oxide layer (62), and a control gate (66),
wherein the first oxide layer (61) separates the charge trapping layer (64) from the body pillar segment (12), and the second oxide layer (62) separates the charge trapping layer (64) from the control gate (66);
wherein the charge trapping layer (64) comprises a dielectric layer and/or a conductive layer;
wherein the control gate (66) is configured to control a current through the body pillar segment (12) of the transistor (2), by a voltage of the control gate (66) relative to the threshold voltage of the transistor (2).

12. The method (100) according to claim 11, wherein the method (100) comprises etching (S104) the semiconductor structure to form a first (41) and a second (42) pillar, each of the first (41) and second (42) pillar having at least one memory cell (50) associated with said pillar (41, 42), the method (100) further comprising:
forming (S110) a common control gate (68), the common control gate (68) being shared between a memory cell (50) of the first pillar (41) and a memory cell (50) of the second pillar (42), the common control gate (68) being configured to simultaneously control a current through the body pillar segment (12) of the transistor (2) of the memory cell (50) of the first pillar (41) and a current through the body pillar segment (12) of the transistor (2) of the memory cell (50) of the second pillar (42), by a voltage of the common control gate (68), wherein the common control gate (68) is formed after etching (S104) the semiconductor structure to form the first (41) and the second pillar (42).

13. The method (100) according to claim 11 or 12,
wherein the first oxide layer (61), the charge trapping layer (64), and the second oxide layer (62) are deposited by one or more conformal depositing techniques, such as atomic-layer deposition, and/or chemical vapor deposition, and/or plasma-enhanced chemical vapor deposition.

14. The method (100) according to any one of claims 11-13,
wherein the control gate (66) is deposited by a directional depositing technique, such as evaporation or sputtering.
